# EUROPÄISCHE PATENTSCHRIFT

(11) **EP 3 259 793 B1**
(45) Veröffentlichungstag und Bekanntmachung des Hinweises auf die Patenterteilung: **13.11.2019**
(21) Anmeldenummer: 16707656.1
(22) Anmeldetag: 16.02.2016
(51) Int. Cl.: H01M 2/34, G01R 31/36, H01M 10/42, H01M 10/48, H02J 7/00

(54) **BATTERIEZELLE FÜR EINE BATTERIE EINES KRAFTFAHRZEUGS, BATTERIE, KRAFTFAHRZEUG UND VERFAHREN ZUM BETREIBEN EINER BATTERIEZELLE**
BATTERY CELL FOR A BATTERY OF A MOTOR VEHICLE, BATTERY, MOTOR VEHICLE AND METHOD FOR OPERATING A BATTERY CELL
ÉLÉMENT DE BATTERIE POUR BATTERIE D'UN VÉHICULE AUTOMOBILE, BATTERIE, VÉHICULE AUTOMOBILE ET PROCÉDÉ PERMETTANT DE FAIRE FONCTIONNER UN ÉLÉMENT DE BATTERIE

(30) Priorität: 18.02.2015 DE 102015002077
(43) Veröffentlichungstag der Anmeldung: 27.12.2017
(73) Patentinhaber: Audi AG, 85045 Ingolstadt (DE)
(72) Erfinder: HELLENTHAL, Berthold, 90596 Schwanstetten (DE); HINTERBERGER, Michael, 85055 Ingolstadt (DE)
(74) Vertreter: Neuhausen, Marc-Alexander
(86) Internationale Anmeldenummer: PCT/EP2016/053207
(87) Internationale Veröffentlichungsnummer: WO 2016/131792

(56) Entgegenhaltungen:
- EP-A2- 2 355 066
- WO-A2-2013/016548
- US-A1- 2014 045 036

## Beschreibung

Die Erfindung betrifft eine Batteriezelle für eine Batterie eines Kraftfahrzeugs. Die Batteriezelle umfasst ein Batteriezellengehäuse, in welchem ein galvanisches Element aufgenommen ist. Über zwei elektrische Anschlüsse kann die Batteriezelle mit wenigstens einer weiteren Batteriezelle der Batterie elektrisch verbunden werden. Eine Steuerungseinrichtung der Batteriezelle ist mit wenigstens einer Funktionseinheit der Batteriezelle wirkverbunden. Des Weiteren betrifft die Erfindung eine Batterie mit einer Mehrzahl solcher Batteriezellen, ein Kraftfahrzeug mit einer Batterie und ein Verfahren zum Betreiben einer Batteriezelle.

Aus dem Stand der Technik etwa der DE 10 2010 045 037 A1 ist es bekannt, eine Mehrzahl von Batteriezellen zum Bereitstellen einer bestimmten Spannung beziehungsweise eines bestimmten Stroms zu einer Batterie zusammenzuschalten. Solche Batterien werden heutzutage insbesondere als Traktionsbatterien in Kraftfahrzeugen wie etwa Elektrofahrzeugen oder Hybridfahrzeugen zum Bereitstellen von elektrischer Antriebsenergie eingesetzt.

Die DE 11 2010 003 272 T5 beschreibt eine Batteriezelle mit in die Batteriezelle integrierten Sensorelementen. Die Sensorelemente sind dazu ausgebildet, Parameter der Batteriezelle wie eine Temperatur, einen Druck, elektrische Größen und elektrochemische Eigenschaften der Batteriezelle zu messen. Die Sensorelemente können mit einer Kommunikationsvorrichtung gekoppelt sein, welche Daten und Informationen an eine außerhalb der Batteriezelle angeordnete Datenverarbeitungsvorrichtung überträgt. Es kann aber auch die Batteriezelle selber mit einer Vorrichtung zur Speicherung, zur Übertragung, zum Empfang und zur Verarbeitung der Daten ausgestattet sein.

Die WO 2013/016548 A2 beschreibt einen elektrischen Energiespeicher, wobei ein Laden oder Entladen des Energiespeichers erst nach einer Authentifizierung einer externen Vorrichtung erlaubt wird, mit welcher der elektrische Energiespeicher verbunden werden soll, um eine Ladung zu empfangen oder Energie abzugeben.

Die US 2014/045036 A1 beschreibt eine Batteriezelle mit einem Gehäuse, in welchem eine Elektrodenanordnung und eine Funktionseinrichtung angeordnet ist. Die Funktionseinrichtung kann Funktionselemente aufweisen, welche zum Detektieren von Betriebsparametern der Batteriezelle und zum Kommunizieren mit einer Batteriesteuereinheit ausgebildet sein können.

Aufgabe der vorliegenden Erfindung ist es, eine verbesserte Batteriezelle der eingangs genannten Art, eine Batterie mit einer Mehrzahl solcher Batteriezellen, ein Kraftfahrzeug mit einer solchen Batterie und ein Verfahren zum Betreiben einer solchen Batteriezelle zu schaffen.

Diese Aufgabe wird durch eine Batteriezelle mit den Merkmalen des Patentanspruchs 1, eine Batterie mit den Merkmalen des Patentanspruchs 8, ein Kraftfahrzeug mit den Merkmalen des Patentanspruchs 9 und durch ein Verfahren mit den Merkmalen des Patentanspruchs 10 gelöst. Vorteilhafte Ausgestaltungen mit zweckmäßigen Weiterbildungen der Erfindung sind in den abhängigen Patentansprüchen angegeben.

Die erfindungsgemäße Batteriezelle für eine Batterie eines Kraftfahrzeugs umfasst ein Batteriezellengehäuse, in welchem ein galvanisches Element aufgenommen ist. Das galvanische Element ist bevorzugt als Sekundärelement ausgebildet, welches zum Versorgen einer elektrischen Komponente entladen und nach der Entladung wieder aufgeladen werden kann. Hierbei umfasst das galvanische Element in an sich bekannter Weise Ableiter etwa in Form von Metallfolien, welche mit dem elektrochemisch aktiven Material der Elektroden des galvanischen Elements beschichtet sind. Des Weiteren ist ein Elektrolyt vorgesehen sowie ein die elektrochemisch aktiven Materialien voneinander trennender Separator. In einem solchen galvanischen Element können die Ableiter gestapelt, gefaltet oder gewickelt vorliegen, so dass das galvanische Element auch als Zellstapel oder Zellwickel bezeichnet wird.

Über die elektrischen Anschlüsse der Batteriezelle kann die Batteriezelle mit wenigstens einer weiteren Batteriezelle der Batterie elektrisch verbunden werden. Eine Steuerungseinrichtung der Batteriezelle ist mit wenigstens einer Funktionseinheit der Batteriezelle wirkverbunden. Hierbei kann die Steuerungseinrichtung insbesondere die wenigstens eine Funktionseinheit ansteuern und/oder von der wenigstens einen Funktionseinheit Messwerte übermittelt bekommen und/oder der wenigstens einen Funktionseinheit Daten übergeben.

Die Steuerungseinrichtung der Batteriezelle ist dazu ausgebildet, einen von einer externen Steuerungseinrichtung ausgegebenen Befehl zu empfangen. Der Befehl kann die Steuerungseinrichtung dazu veranlassen, mit der wenigstens einen Funktionseinheit zu interagieren. Hierbei umfasst die Steuerungseinrichtung eine Überprüfungseinheit, welche dazu ausgebildet ist, eine Berechtigung der externen Steuerungseinrichtung zum Ausgeben des Befehls zu überprüfen. So kann sichergestellt werden, dass nur eine berechtigte externe Steuerungseinrichtung in der Art und Weise auf die Steuerungseinrichtung der Batteriezelle zugreifen kann, dass in der Folge die Steuerungseinrichtung der Batteriezelle mit der wenigstens einen Funktionseinheit interagiert. Auf diese Weise ist ein gesicherter Zugang zu der Steuerungseinrichtung der Batteriezelle gewährleistet, und eine unerlaubte Manipulation der mit der Steuerungseinrichtung ausgestatteten Batteriezelle ist vermieden. Dadurch ist eine verbesserte Batteriezelle geschaffen.

Durch das Vorsehen der Steuerungseinrichtung ist der Batteriezelle eine Intelligenz verliehen, die Batteriezelle also als sogenannte "SmartCell" (intelligente Batteriezelle) ausgebildet. Bei der Steuerungseinrichtung kann es sich um eine lokale Recheneinheit etwa in Form eines Mikrokontrollers, einer anwendungsspezifischen integrierten Schaltung (ASIC, application-specific integrated circuit) oder eines FPGA (field programmable gate array, im Feld programmierbare Gatter-Anordnung) handeln.

Bei der externen Steuerungseinrichtung kann es sich um die Steuerungseinrichtung einer weiteren Batteriezelle der Batterie handeln. Bevorzugt ist jedoch die externe Steuerungseinrichtung als übergeordnetes Steuergerät ausgebildet, welches zum Ausgeben von Befehlen an eine Mehrzahl von Batteriezellen der Batterie in der Lage ist.

Die wenigstens eine Funktionseinheit der Batteriezelle kann ein Schaltelement umfassen, welches zum Unterbrechen und zum Herstellen einer elektrisch leitenden Verbindung zwischen einem Ableiter des galvanischen Elements und zumindest einem der elektrischen Anschlüsse ausgebildet ist. Hierbei ist die Steuerungseinrichtung der Batteriezelle dazu ausgebildet, auf den Befehl der externen Steuerungseinrichtung hin einen Schaltzustand des Schaltelements zu verändern.

Dies erlaubt es zumindest einen der elektrischen Anschlüsse - und bei Vorsehen von zwei Schaltelementen die beiden elektrischen Anschlüsse der Batteriezelle - spannungsfrei zu schalten. So kann dafür gesorgt werden, dass an den elektrischen Anschlüssen der Batteriezelle nur dann eine elektrische Spannung anliegt, wenn dies gewünscht ist. Dies ermöglicht einen besonders sicheren Betrieb der und Umgang mit der Batteriezelle. Eine Batteriezelle, deren elektrische Anschlüsse spannungsfrei geschaltet sind, kann nämlich gefahrlos gehandhabt werden. Zudem kann beim Auftreten eines Fehlers der Batteriezelle die elektrisch leitende Verbindung zwischen dem Ableiter und zumindest einem der elektrischen Anschlüsse getrennt werden. Dadurch kann von dieser Batteriezelle keine Gefahr mehr ausgehen.

Durch das Öffnen des Schaltelements, welches die elektrisch leitende Verbindung zwischen dem Ableiter und dem Anschluss unterbricht, wird quasi die Batteriezelle vom Netz getrennt.

Es kann so insbesondere während des Zusammenbauens einer Batterie, welche eine Vielzahl der Batteriezellen umfassen und entsprechend eine hohe Spannung bereitstellen kann, ein Hochvoltschutz sichergestellt werden. Bei der Batterie kann es sich nämlich insbesondere um eine Hochvoltbatterie handeln, also um eine Batterie, welche eine Spannung von mehr als 60 Volt aufweist. Insbesondere kann die Hochvoltbatterie dazu ausgebildet sein, Spannungen bereitzustellen, wie sie für Traktionsbatterien von Kraftfahrzeugen zum Einsatz kommen, also Spannungen im Bereich von mehreren hundert Volt. Durch das Unterbrechen der elektrisch leitenden Verbindung kann auch in einem Transportzustand, wenn also beispielsweise die Batterie zu ihrem Einsatzort hin transportiert wird, dafür gesorgt werden, dass von der Batterie keine mit einer hohen Spannung verbundenen Gefahren ausgehen.

Das Schaltelement, mittels welchem sich die elektrisch leitende Verbindung zwischen dem Ableiter und dem zumindest einen Anschluss der Batteriezelle unterbrechen lässt, kann auch als Stromunterbrechungseinrichtung (current interrupt device, CID) bezeichnet werden. Bei der vorliegenden Ausgestaltung handelt es sich bevorzugt um eine elektronische Stromunterbrechungseinrichtung, welche von der Steuerungseinrichtung oder Recheneinheit der Batteriezelle geschaltet wird. Hierfür kann das Schaltelement insbesondere als Halbleiterbauelement ausgebildet sein, welches zum Vorgeben des jeweiligen Schaltzustands von der Steuerungseinrichtung der Batteriezelle mit einer Steuerspannung beaufschlagt wird. Dies erlaubt es insbesondere, beim gezielten Unterbrechen der elektrisch leitenden Verbindung eine Vielzahl von Parametern zu berücksichtigen, etwa durch Festlegen von Schaltkriterien in der Steuerungseinrichtung der Batteriezelle.

Des Weiteren kann auf den Befehl hin das Schaltelement geschlossen werden, sodass die elektrisch leitende Verbindung hergestellt ist. Dann liegt an den Anschlüssen der Batteriezelle die Spannung des galvanischen Elements an. Jedoch ist nur die berechtigte externe Steuerungseinrichtung dazu in der Lage, tatsächlich das Schaltelement mittels der batteriezellinternen Steuerungseinrichtung betätigen zu lassen, also den Schaltzustand wie gewünscht zu verändern. Dies macht das Schalten des Schaltelements besonders sicher.

Zum Verändern des Schaltzustands des Schaltelements, also zum Betreiben dieses Trennschalters, können unterschiedliche Befehle vorgesehen sein. So kann ein erster Befehl das Schließen des Trennschalters bewirken, also das Verbringen des Schaltelements in den Schaltzustand, in welchem die elektrisch leitende Verbindung zwischen dem Ableiter und dem galvanischen Element hergestellt ist. Ein weiterer Befehl kann das Öffnen des Trennschalters bewirken, also das Unterbrechen der elektrisch leitenden Verbindung.

Die Befehle zum Betreiben des Schaltelements sind bevorzugt verschlüsselt, wobei beim Vorsehen einer Vielzahl der Batteriezellen in der Batterie für jede Batteriezelle ein gesonderter Schlüssel vorgesehen sein kann. Um einen besonders sicheren Schlüssel bereitzustellen, kann der jeweilige Schlüssel eine Länge von beispielsweise mindestens 24 Bit haben.

Schlüssel zum Entschlüsseln des jeweiligen Befehls können in einem einmal programmierbaren Speicher oder OTP-Speicher (OTP = one time programmable) der Batteriezelle abgelegt sein. Die verschlüsselten Befehle können von der als berechtigt überprüften externen Steuerungseinrichtung aus einem solchen Speicher ausgelesen werden, sodass das Schaltelement von der externen Steuerungseinrichtung durch Ausgeben des Befehls an die Steuerungseinrichtung der Batteriezelle bedient werden kann. Dennoch bleibt hierbei das Bedienen selber verschlüsselt und somit besonders sicher.

Eine besonders große Sicherheit kann des Weiteren dadurch erreicht werden, dass sich der Befehl zum Schließen des Schaltelements vergleichsweise stark vom Befehl zum Öffnen des Schaltelements unterscheidet. Dann kann nicht beispielsweise ein versehentliches Kippen lediglich eines Bits dazu führen, dass der falsche, also in diesem Fall gar nicht gewünschte Befehl ausgeführt wird.

Als weiter vorteilhaft hat es sich gezeigt, wenn die Steuerungseinrichtung der Batteriezelle dazu ausgebildet ist, in Abhängigkeit von einem erneuten Empfangen eines Befehls einen geschlossenen Schaltzustand des Schaltelements beizubehalten. Ein solcher Befehl kann auch als keep-alive-Befehl, also als am Leben haltender Befehl bezeichnet werden, da ansonsten das Schaltelement öffnet und die Batteriezelle keine Spannung mehr an den Anschlüssen bereitstellt. Durch die Implementierung eines solchen keep-alive-Befehls ist eine kontinuierliche, kontrollierte Funktion der Batteriezelle beziehungsweise ein am-Netz-Bleiben der Batteriezelle sichergestellt.

Dennoch erfolgt ein automatisches Öffnen des Schaltelements, also ein Unterbrechen der elektrisch leitenden Verbindung, wenn der wachhaltende beziehungsweise am Leben erhaltende Befehl (keep-alive-Befehl) nicht empfangen wird. So kann insbesondere sichergestellt werden, dass nach einer ausreichend langen Untätigkeit der externen Steuerungseinrichtung die Batteriezelle abgeschaltet wird. Ist die Batteriezelle mit weiteren Batteriezellen der Batterie in Reihe geschaltet, so führt dies zugleich zu einem Spannungsfrei-Schalten der gesamten Batterie. So ist insgesamt bei lange ruhendem Betrieb eine hohe Sicherheit in Bezug auf die von der Batteriezelle oder von der Batterie bereitgestellte Spannung sichergestellt. Auch dieser den Betrieb am Leben erhaltende Befehl ist bevorzugt verschlüsselt und in Bezug auf die Bitfolge den weiteren Befehlen für den Betrieb des Schaltelements unähnlich.

Es kann vorgesehen sein, dass der Befehl, den geschlossenen Schaltzustand des Schaltelements beizubehalten, nach Ablauf einer vorbestimmten Zeitspanne (etwa einer Zeitspanne von einigen Sekunden) und/oder nach einem vorbestimmten Energiefluss aus der Batteriezelle oder in die Batteriezelle von der Steuerungseinrichtung der Batteriezelle empfangen werden muss, damit nicht die elektrisch leitende Verbindung zwischen dem Ableiter und dem Anschluss unterbrochen wird. Auch kann vorgesehen sein, dass das Schaltelement öffnet, wenn nach Verstreichen dieser Zeitspanne oder nach Erreichen des vorgegebenen Werts des Energieflusses eine weitere Zeitspanne verstrichen ist und/oder ein weiterer Energiefluss in die Batteriezelle hinein oder aus der Batteriezelle heraus erfolgt ist. Dies macht die Implementierung des keep-alive-Befehls besonders funktionssicher. Der Energiefluss kann insbesondere in Wattsekunden bestimmt werden.

Zusätzlich oder alternativ kann die wenigstens eine Funktionseinheit der Batteriezelle ein Schaltelement umfassen, welches in einer Leitung angeordnet ist, welche die Ableiter des galvanischen Elements miteinander verbindet. Hierbei ist in der Leitung ein Widerstandselement angeordnet. Die Steuerungseinrichtung der Batteriezelle ist dazu ausgebildet, auf den Befehl hin das Schaltelement zu schließen. Das Schließen dieses in der Leitung angeordneten Schaltelements sorgt also dafür, dass die Ableiter des galvanischen Elements elektrisch leitend miteinander verbunden werden wobei der Strom über das Widerstandselement fließt. Dies führt zu einem aktiven lokalen Entladen der Batteriezelle.

So kann falls gewünscht, nicht nur dafür gesorgt werden, dass an den elektrischen Anschlüssen der Batteriezelle keine Spannung mehr anliegt. Vielmehr kann selbst die von dem galvanischen Element bereitgestellte Spannung gezielt verringert werden. Dies geschieht zwar nicht so schlagartig wie das Spannungsfrei-Schalten der Anschlüsse der Batteriezelle, jedoch kann so eine besonders große Sicherheit im Umgang mit der Batteriezelle erreicht werden.

Dies gilt insbesondere, wenn durch Schließen des in der Leitung angeordneten Schaltelements die Batteriezelle tiefentladen wird, also derart, dass ein späteres Laden der Batteriezelle unmöglich gemacht wird. Durch eine solche aktive Tiefenentladung wird auch ein späteres Laden durch parasitäre oder chemische Effekte unterbunden. Auf diese Weise abgeschaltete Batteriezellen können nach Ablauf der Entladezeit gefahrlos einer Entsorgung oder einem Recycling zugeführt werden, bei welchem die Batteriezellen beispielsweise in ihre Bestandteile zerlegt werden können.

Auch der Befehl zum Entladen der Batteriezelle, also zum Schließen des in der Leitung angeordneten Schaltelements ist bevorzugt verschlüsselt und den übrigen Befehlen zum Betreiben des Schaltelements ausreichend unähnlich. Beispielsweise können mehr als 10% der Bits, insbesondere mehr als 25 % der Bits, unterschiedlich sein, um eine ausreichende Unähnlichkeit der Befehle sicherzustellen.

Des Weiteren kann vorgesehen sein, dass durch einen Befehl, welcher das Schließen des in der Leitung angeordneten Schaltelements bewirkt, zugleich ein Schließen des Schaltelements unmöglich gemacht wird, bei welchem im geöffneten Schaltzustand die elektrisch leitende Verbindung zwischen dem Ableiter und dem elektrischen Anschluss unterbrochen ist. Dann kann auch während des (Tief-)Entladens der Batteriezelle keine Spannung an den elektrischen Anschlüssen der Batteriezelle anliegen. Das Unmöglichmachen des Schließens dieses Schaltelements kann insbesondere bei der aktiven lokalen Entladung vorgesehen sein, welche die Batteriezelle im Hinblick auf ein späteres Geladenwerden unbrauchbar macht. Dies kann insbesondere erreicht werden, indem in einem einmal programmierbaren Speicher der Batteriezelle eine entsprechende Sequenz programmiert wird.

Von Vorteil ist, dass die Batteriezelle eine von der externen Steuerungseinrichtung auslesbare Kennung aufweist. Hierbei kann es sich insbesondere um eine Identifikationsnummer, beispielsweise eine digitale öffentliche Identifikationsnummer handeln. Eine solche Identifikationsnummer kann eine Länge von mindestens 16 Bit und insbesondere von mindestens 64 Bit haben, sodass auch bei einer Batterie mit einer Vielzahl von Batteriezellen jede Batteriezelle eineindeutig identifiziert werden kann. Diese Identifikationsnummer kann von jeder externen Steuerungseinrichtung ausgelesen werden, welche überhaupt berechtigt ist, mit der Steuerungseinrichtung der Batteriezelle zu kommunizieren.

Die Steuerungseinrichtung der Batteriezelle ist dazu ausgebildet, beim Empfangen wenigstens eines vorbestimmten Sonderbefehls unabhängig von der Kennung der Batteriezelle das zwischen dem Ableiter und dem zumindest einen elektrischen Anschluss angeordnete Schaltelement zu öffnen. Bei diesem Sonderbefehl kann es sich also um eine Art Notfallnachricht handeln, welche zum Unterbrechen der elektrisch leitenden Verbindung zwischen dem Ableiter und dem Anschluss der Batteriezelle führt. So kann für ein sicheres Spannungsfrei-Schalten der Batteriezelle gesorgt werden. Dies ist etwa vorteilhaft, wenn die Batteriezelle in einer Batterie eines Kraftfahrzeugs angeordnet ist und Rettungskräfte nach einem Unfall des Kraftfahrzeugs die Batterie spannungsfrei schalten wollen. Ein solcher Sonderbefehl in Form einer Notfallnachricht kann beispielsweise eine Länge von mindestens 1.024 Bit haben, sodass der Befehl besonders sicher ist. Jedoch nicht nur bei Unfällen eines mit der Batterie ausgestatteten Fahrzeugs ist das Nutzen des Sonderbefehls oder der Notfallnachricht sinnvoll, auf welchen jede Batteriezelle der Batterie reagiert. Auch beim Schalten der Batteriezelle beziehungsweise der Batterie in einen Transportmodus kann so ohne eine aufwendige Kommunikation eine besonders große Sicherheit erreicht werden.

Wenn die Batteriezelle das in der Leitung angeordnete Schaltelement aufweist, so ist bevorzugt die Steuerungseinrichtung der Batteriezelle dazu ausgebildet, beim Empfangen wenigstens eines vorbestimmten Sonderbefehls unabhängig von der Kennung der Batteriezelle das in der Leitung angeordnete Schaltelement zu schließen. Dies dient einem Erhöhen der Sicherheit im Umgang mit der Batteriezelle beziehungsweise der Batterie, da durch Schließen des in der Leitung angeordneten Schaltelements die Batteriezelle final entladen werden kann. Es kann also ein finaler Lagermodus der Batteriezelle herbeigeführt werden, in welchem die Batteriezelle nicht mehr zum Aufnehmen oder Abgeben von elektrischer Energie eingesetzt werden kann. Ein entsprechender Sonderbefehl, welcher die Batteriezelle unbrauchbar macht, kann bevorzugt eine Länge von wenigstens 2.048 Bit aufweisen, um eine besonders große Sicherheit zu gewährleisten.

Als weiter vorteilhaft hat es sich gezeigt, wenn die wenigstens eine Funktionseinheit der Batteriezelle einen Speicher zum Speichern von Datenwerten umfasst, wobei die Datenwerte Parameter angeben, welche mittels wenigstens einer Sensoreinrichtung der Batteriezelle erfasst werden können. Hierbei ist die Steuerungseinrichtung der Batteriezelle dazu ausgebildet, auf den Befehl hin auf den Speicher zuzugreifen. Durch das Erfassen der Parameter können Informationen über die Historie der Batteriezelle gesammelt und für eine Auswertung dokumentiert werden. Vorliegend kann jedoch sichergestellt werden, dass lediglich die Steuerungseinrichtung der Batteriezelle auf den Speicher zugreifen darf und nicht die externe Sensoreinrichtung direkt. So kann sichergestellt werden, dass nicht alle Datenwerte, welche die Batteriezelle betreffen, frei zugänglich sind. Mit anderen Worten kann entschieden werden, ob Datenwerte frei zugänglich sein sollen, und für welche Datenwerte zunächst die Berechtigung der externen Steuerungseinrichtung zum Abfragen der Datenwerte geprüft werden soll. Dadurch ist das Aufzeichnen der Historie der Batteriezelle besonders sicher, und ein Werterhalt der Batteriezelle kann gewährleistet werden. Es kann nämlich lückenlos und einbruchsicher das Leben der Batteriezelle dokumentiert werden.

Wenn der eigentliche Zugriff auf den Speicher nur über die lokale Steuerungseinrichtung der Batteriezelle erfolgt, so führt eine Zerstörung der Steuerungseinrichtung der Batteriezelle dazu, dass die gespeicherten Daten nicht mehr ausgelesen werden können. So kann sichergestellt werden, dass der Speicher der Batteriezelle lediglich mit der Steuerungseinrichtung funktioniert, welche für die Batteriezelle vorgesehen ist. Wird beim Zugreifen auf den Speicher zusätzlich eine Verschlüsselung benutzt, so kann ausschließlich die Steuerungseinrichtung beziehungsweise der Mikrokontroller auf den Speicher zugreifen, welche oder welcher den richtigen Schlüssel besitzt, etwa in seinem lokalen, insbesondere einmal programmierbaren Speicher.

Bei dem Speicher für die Datenwerte kann es sich insbesondere um einen lokalen, nicht volatilen Speicher etwa in Form eines Flashspeichers, eines EEPROM (electrically erasable programmable read-only memory, elektrisch löschbarer programmierbarer Nur-Lese-Speicher), eines FeRAM (Ferroelectric Random Access Memory, ferroelektrischer Speicher mit wahlfreiem oder direktem Zugriff) oder eines MRAM (Magnetoresistives Random Access Memory) handeln. Ein solcher nicht volatiler Speicher kann sich in der Steuerungseinrichtung befinden oder extern an diese angebunden sein.

Zum Lesen, Hinzufügen oder Speichern beziehungsweise Überschreiben von Daten können jeweils verschlüsselte Befehle vorgesehen sein, wobei der Schlüssel beispielsweise in der Steuerungseinrichtung abgelegt sein kann. Der Schlüssel in der Steuerungseinrichtung der Batteriezelle kann also zum Verschlüsseln der Daten im nicht flüchtigen Speicher verwendet werden. So kann sichergestellt werden, dass beispielsweise das Lesen und Schreiben von Daten im nicht flüchtigen Speicher ausschließlich über die lokale Steuerungseinrichtung möglich ist. Dies sorgt für eine besonders große Sicherheit der im Speicher der Batteriezelle vorhandenen Daten.

Als weiter vorteilhaft hat es sich gezeigt, wenn wenigstens ein Schlüssel vorgesehen ist, mittels welchem an die externe Steuerungseinrichtung zu übermittelnde Informationen verschlüsselt werden. Hierbei kann zumindest ein Teil oder die gesamte Kommunikation verschlüsselt werden, etwa durch eine AES-128-Verschlüsselung. Zusätzlich oder alternativ zu einer solchen symmetrischen Verschlüsselung können auch asymmetrische Verschlüsselungsverfahren zum Einsatz kommen, bei welchen in der Batteriezelle insbesondere mehrere private und öffentliche Schlüssel hinterlegt sind.

Beispielsweise kann der wenigstens eine private Schlüssel sich in einem einmal programmierbaren Speicher (OTP-Speicher) der Batteriezelle befinden, sodass der private Schlüssel nur sehr schwer von außen zugänglich ist. Der wenigstens eine öffentliche Schlüssel kann hingegen sowohl in einem nicht volatilen Speicher der Batteriezelle abgelegt sein und zusätzlich im OTP-Speicher. Der öffentliche Schlüssel kann hierbei von jeder externen Steuerungseinrichtung ausgelesen werden, welche überhaupt mit der Steuerungseinrichtung der Batteriezelle zu kommunizieren berechtigt ist. Durch das Verwenden derartiger Schlüssel kann sichergestellt werden, dass die von der Batteriezelle an die externe Steuerungseinrichtung übermittelten Informationen nicht mitgelesen oder kopiert werden können. Dies sorgt für eine besonders sichere Informationsübermittlung.

Wenigstens ein Schlüssel kann auch zum Verschlüsseln von in einem Speicher der Batteriezelle abzulegenden Daten zum Einsatz kommen. Dann kann selbst im Falle eines unerwünschten Zugriffs auf den die Daten enthaltenden Speicher nichts mit den ausgelesenen Daten angefangen werden.

Bevorzugt ist des Weiteren wenigstens ein Schlüssel vorgesehen, mittels welchem sich die von der externen Steuerungseinrichtung ausgegebenen Befehle entschlüsseln lassen. Auch hier können insbesondere private Schlüssel zum Einsatz kommen, da dann kein Aufwand betrieben zu werden braucht, den zum Verschlüsseln des Befehls eingesetzten Schlüssel geheim zu halten. Solche privaten Schlüssel ermöglichen also die verschlüsselte Kommunikation beim Zugriff auf die verschiedenen Funktionseinheiten der Batteriezelle. Hierbei kann ein privater Schlüssel für alle Funktionseinheiten vorgesehen sein. Alternativ können für jeweilige Funktionen jeweilige private Schlüssel vorgesehen sein.

Bei der Verwendung von mehreren Schlüsseln kann vorgesehen sein, dass die Steuerungseinrichtung der Batteriezelle der externen Steuerungseinrichtung beim Übermitteln einer jeweiligen Nachricht mitteilt, welcher (insbesondere private) Schlüssel zum Verschlüsseln der nächsten, also darauffolgenden Nachricht eingesetzt werden soll. Somit ist auch bei gleichem Inhalt der Nachricht die Bitfolge der jeweiligen Nachricht jeweils anders. Auch dies erschwert ein Abhören der Kommunikation zwischen der Steuerungseinrichtung der Batteriezelle und der externen Steuerungseinrichtung.

Des Weiteren kann eine gestaffelte Sicherheitshierarchie vorgesehen sein. Hierfür kann die Überwachungseinheit dazu ausgebildet sein, eine Zugriffskontrolle durchzuführen, bei welcher das vorherige Ausführen eines ersten, hierarchisch übergeordneten Befehls die Voraussetzungen für das Ausführen eines zweiten, hierarchisch untergeordneten Befehls ist. Der Zugang zur jeweils höheren Ebene ist somit die Voraussetzung zum Freischalten der nächst tieferen Ebene. Ein direkter Zugriff auf Funktionen, welche sich auf der tiefsten Ebene befinden, ist somit erst nach Freigabe aller Funktionen auf höheren Ebenen möglich. Auch auf diesem Wege kann eine besonders große Sicherheit im Umgang mit den Daten der Batteriezelle und beim Ausführen von die Funktionseinheiten der Batteriezelle betreffenden Befehlen gewährleistet werden.

Derartige insbesondere mehrstufig abgesicherte Funktionen können beispielsweise unterschiedliche Geheimnisebenen für das Lesen von Daten, das Hinzufügen von Daten und das Speichern oder Überschreiben von Daten vorsehen. Auch kann insbesondere das Betreiben des Schaltelements davon abhängig gemacht werden, ob zuvor eine Funktion mit weniger kritischem Inhalt zugelassen wurde wie etwa das Auslesen von Daten.

Wenn die externe Steuerungseinrichtung diese Kennung (insbesondere Identifikationsnummer) ausgelesen hat, so kann beispielsweise für die externe Steuerungseinrichtung der Zugriff auf Informationen freigegeben werden, welche den Schaltzustand des Schaltelements betreffen und/oder die Spannung der Batteriezelle und/oder die Stromstärke beim Laden und/oder Entladen der Batteriezelle und/oder eine Temperatur der Batteriezelle und/oder einen Druck im Inneren des Batteriezellengehäuses. Größen wie die Temperatur und der Druck können hierbei von entsprechenden Sensoreinrichtungen der Batteriezelle erfasst werden, während insbesondere der Schaltzustand des Schaltelements, die Spannung und die Stromstärke auch direkt von der Steuerungseinrichtung der Batteriezelle erfasst werden können.

Die Befehle für das Auslesen einer oder mehrerer der vorstehend genannten Informationen können öffentlich zugänglich sein. Es kann jedoch auch vorgesehen sein, dass zunächst die Steuerungseinrichtung der Batteriezelle zum Kommunizieren der entsprechenden Informationen aufgefordert wird und hierbei die Kennung oder Identifikationsnummer der jeweiligen Batteriezelle mitzuliefern ist, damit die Steuerungseinrichtung der Batteriezelle mit den entsprechenden Statusinformationen antwortet. Es kann also ein individuelles Ansprechen der einzelnen Batteriezellen der Batterie die Voraussetzung für ein Ausgeben der entsprechenden Informationen sein.

Das Vorsehen der Kennung der jeweiligen Batteriezelle sorgt entsprechend für eine besonders sichere und geordnete Kommunikation zwischen der Steuerungseinrichtung der Batteriezelle und der externen Steuerungseinrichtung.

Als weiter vorteilhaft hat es sich gezeigt, wenn die Steuerungseinrichtung der Batteriezelle wenigstens ein Sicherungselement aufweist, welches derart angeordnet ist, dass es infolge eines mechanischen Manipulierens der Steuerungseinrichtung beschädigt wird. Beispielsweise können ein oder mehrere Eingänge der Steuerungseinrichtung mit einem solchen Sicherungselement verbunden sein, welches auch als Tripdraht, Tripwire oder Fusedraht bezeichnet wird. Das Durchtrennen eines solchen Drahts (etwa beim Versuch die Steuerungseinrichtung zu öffnen) wird im Betrieb der Steuerungseinrichtung von dieser erkannt. Dies kann unmittelbar beim Beschädigen des Sicherungselements geschehen oder beim nächsten Starten oder Herauffahren der Steuerungseinrichtung.

Die Steuerungseinrichtung ist hierbei bevorzugt dazu ausgelegt, eine Intrusionssequenz oder dergleichen Datensatz in einen Speicher zu schreiben. Wird eine solche Intrusionssequenz aufgefunden, so wird beispielsweise ein Zugriff auf den Speicher, insbesondere das Lesen und/oder Schreiben, unterbunden und entsprechend nicht mehr ausgeführt. So kann insbesondere sichergestellt werden, dass nur die originale Steuerungseinrichtung die jeweilige Funktionseinheit ansprechen kann.

Sicherungselemente wie etwa Fusedrähte können in das Package oder Modul der Steuerungseinrichtung eingebettet sein oder um das Package und/oder durch das Package führen. Auch können derartige Sicherungselemente als Leiterbahnen auf einem Schaltungsträger ausgeführt sein. Des Weiteren ist es möglich, derartige Sicherungselemente als Bestandteile einer obersten und einer untersten Metallschicht eines Halbleiterbausteins auszubilden, welcher zu der Steuerungseinrichtung der Batteriezelle gehört oder die Steuerungseinrichtung der Batteriezelle bildet.

Beim Versuch des Öffnens der Steuerungseinrichtung oder einer derartigen Manipulation derselben wird insbesondere wenigstens ein solches Sicherungselement beschädigt oder vollständig durchtrennt. Daraufhin kann die Steuerungseinrichtung dafür sorgen, dass ein Zugriff auf die zumindest eine Funktionseinheit der Batteriezelle unterbunden wird. Insbesondere kann dafür gesorgt werden, das alle Daten gelöscht werden, welche in einer als Speicher ausgebildeten Funktionseinheit der Batteriezelle abgelegt sind. Durch ein derartiges Sicherungselement ist ein besonders weitgehender Schutz vor Manipulationen an der Batteriezelle gewährleistet. Dies sichert den Wert der Batteriezelle. Insbesondere kann sichergestellt werden, dass ein Auslesens eines Speichers der Batteriezelle nach dem Durchtrennen eines Fusedrahts nicht mehr möglich ist. So kann insbesondere eine besonders große Sicherheit im Hinblick auf die Historie der Batteriezelle gewährleistet werden.

Die erfindungsgemäße Batterie umfasst eine Mehrzahl von erfindungsgemäßen Batteriezellen, welche in Reihe geschaltet und/oder parallel geschaltet sein können.

Das erfindungsgemäße Kraftfahrzeug umfasst zumindest eine erfindungsgemäße Batterie. Das Kraftfahrzeug kann beispielsweise als Personenkraftwagen, insbesondere als ein Elektrofahrzeug oder Hybridfahrzeug ausgebildet sein. Des Weiteren kann es sich bei dem Kraftfahrzeug auch um ein elektrisch betriebenes Motorrad oder um ein elektrisch betriebenes Fahrrad handeln.

Es ist des Weiteren möglich, die Batterie in einem stationären Energiespeichersystem vorzusehen. Darüber hinaus kann es vorgesehen sein, dass die Batterie, welche in einem Kraftfahrzeug bereitgestellt war, als sogenannte Second Life Batterie weiterverwendet wird, bei welcher also die Batterie einer anders gearteten Nutzung zugeführt wird. Insbesondere bei Second Life Anwendungen können nämlich die Anforderungen etwa an die Leistungsfähigkeit der Batteriezellen geringer sein als bei Verwendung der Batteriezellen für die Batterie des Kraftfahrzeugs.

Das erfindungsgemäße Verfahren dient dem Betreiben einer Batteriezelle für eine Batterie eines Kraftfahrzeugs, welche ein Batteriezellengehäuse mit einem in dem Batteriezellengehäuse aufgenommenen galvanischen Element umfasst. Die jeweilige Batteriezelle weist zwei elektrische Anschlüsse auf, über welche die Batteriezelle mit wenigstens einer weiteren Batteriezelle der Batterie elektrisch verbunden werden kann. Eine Steuerungseinrichtung der Batteriezelle ist mit wenigstens einer Funktionseinheit der Batteriezelle wirkverbunden. Hierbei empfängt die Steuerungseinrichtung der Batteriezelle einen von einer externen Steuerungseinrichtung ausgegebenen Befehl. Die Steuerungseinrichtung umfasst eine Überprüfungseinheit, welche eine Berechtigung der externen Steuerungseinrichtung zum Ausgeben des Befehls überprüft. Durch ein solches Verfahren ist ein (insbesondere digitales) Sicherheitskonzept und Datensicherheitskonzept für intelligente Batteriezellen bereitgestellt. Des Weiteren betrifft das Verfahren den Betrieb einer Batterie mit einer Mehrzahl der Batteriezellen.

Die für die erfindungsgemäße Batteriezelle beschriebenen Vorteile und bevorzugten Ausführungsformen gelten auch für die erfindungsgemäße Batterie, für das erfindungsgemäße Kraftfahrzeug und für das erfindungsgemäße Verfahren.

Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen als von der Erfindung umfasst und offenbart anzusehen, die in den Figuren nicht explizit gezeigt oder erläutert sind, jedoch durch separierte Merkmalskombinationen aus den erläuterten Ausführungen hervorgehen und erzeugbar sind.

Weitere Vorteile, Merkmale und Einzelheiten der Erfindung ergeben sich aus den Ansprüchen, der nachfolgenden Beschreibung bevorzugter Ausführungsformen sowie anhand der Zeichnungen. Dabei zeigen:
- Fig. 1: schematisch eine Batteriezelle für eine Batterie eines Kraftfahrzeugs, welche zur sicheren Kommunikation mit einem übergeordneten Steuergerät ausgebildet ist;
- Fig. 2: schematisch Komponenten der Batteriezelle gemäß Fig. 1;
- Fig. 3: das übergeordnete Steuergerät, welches zur Kommunikation mit einer Mehrzahl von Batteriezellen gemäß Fig. 1 ausgebildet ist und welches freigeschaltet wird; und
- Fig. 4: das übergeordnete Steuergerät, welches mit den Batteriezellen der Batterie kommuniziert.

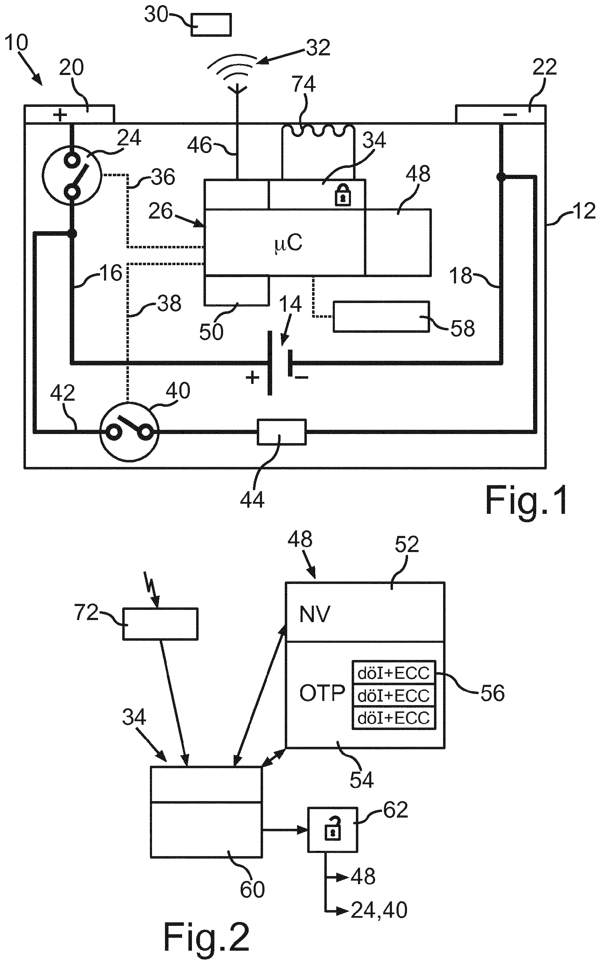

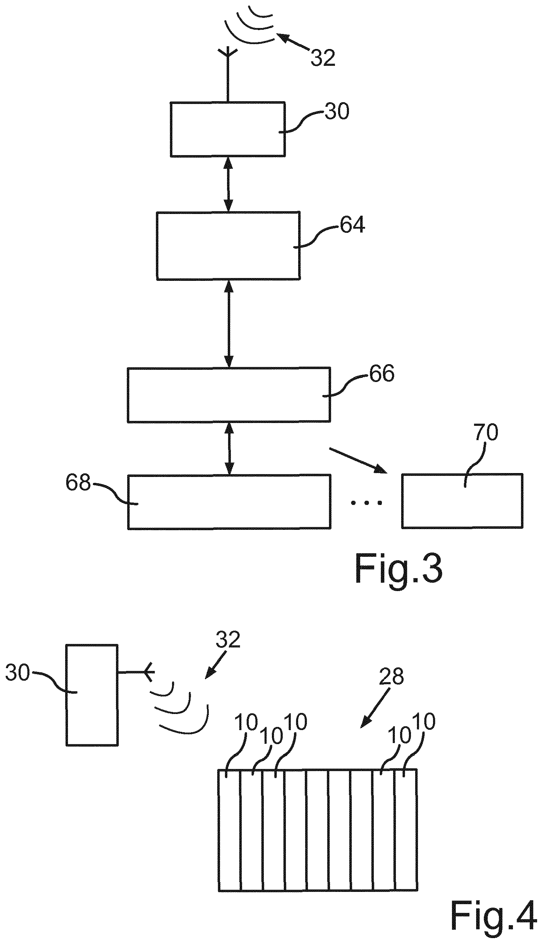

In Fig. 1 ist schematisch eine Batteriezelle 10 gezeigt, wie sie beispielsweise in einer Batterie 28 (vergleiche Fig. 4) eines Kraftfahrzeugs zum Einsatz kommen kann. Die Batteriezelle 10 kann hierfür etwa als Lithium-Ionen-Zelle ausgebildet sein. In der Batterie 28, welche in dem Kraftfahrzeug als Traktionsbatterie dienen kann, ist üblicherweise eine Vielzahl solcher Batteriezellen 10 elektrisch in Reihe und/oder parallel geschaltet, um entsprechend hohe Spannungen und Ströme bereitzustellen.

Bei einer Reihenschaltung solcher Batteriezellen 10 kann insgesamt eine sehr hohe Spannung und zwar eine Spannung von mehreren hundert Volt der Batterie 28 auftreten, etwa weil mehrere Batteriemodule, welche jeweils eine Mehrzahl von Batteriezellen 10 enthalten, elektrisch leitend miteinander verbunden sind.

Die Batteriezelle 10 umfasst ein Batteriezellengehäuse 12, welches vorliegend beispielhaft prismatisch ausgebildet ist. Innerhalb des Batteriezellengehäuses 12 ist ein galvanisches Element 14 angeordnet, welches mit einem jeweiligen elektrochemischen Material beschichtete Ableiter 16, 18 umfasst. Vorliegend sind von den das elektrochemisch aktive Material und die Ableiter 16, 18 umfassenden Elektroden des galvanischen Elements 14 zur Vereinfachung lediglich der zu einem ersten elektrischen Anschluss 20 (etwa einem Pluspol) der Batteriezelle 10 führende Ableiter 16 gezeigt und der zu einem zweiten elektrischen Anschluss 22 der Batteriezelle 10 führende Ableiter 18, also der zum Minuspol führende Ableiter 18.

Bei der in Fig. 1 gezeigten Batteriezelle 10 ist es möglich, das galvanische Element 14 elektrisch von zumindest einem der Anschlüsse 20, 22 zu trennen. Hierfür ist ein Schaltelement 24 vorgesehen, mittels welchem sich eine elektrisch leitende Verbindung zwischen dem Ableiter 16 und dem Anschluss 20 unterbrechen lässt, indem das Schaltelement 24 geöffnet wird. Durch Schließen des Schaltelements 24 lässt sich die elektrisch leitende Verbindung zwischen dem Ableiter 16 und dem Anschluss 20 wieder herstellen.

In analoger Weise kann ein (nicht gezeigtes) zweites Schaltelement vorgesehen, mittels welchem sich die elektrisch leitende Verbindung zwischen dem Ableiter 18 und dem Anschluss 22 unterbrechen beziehungsweise herstellen lässt. Das Schaltelement 24, welches insbesondere als Halbleiterelement ausgebildet sein kann, wird beispielsweise von einer als Mikrokontroller 26 ausgebildeten Steuerungseinrichtung der Batteriezelle 10 geschaltet. Der Mikrokontroller 26 ist vorliegend ebenso wie das Schaltelement 24 innerhalb des Batteriezellengehäuses 12 angeordnet.

Dem Mikrokontroller 26 kann von einer externen Steuerungseinrichtung, etwa von einem übergeordneten Steuergerät 30, ein Befehl 32 übermittelt werden, das Schaltelement 24 zu schließen oder zu öffnen. Das übergeordnete Steuergerät 30 kann auch als ein sogenannter SmartCell-Controller bezeichnet werden. Vorliegend ist sichergestellt, dass nicht eine jede externe Steuerungseinrichtung den Mikrokontroller 26 zum Ausführen des Befehls 32 veranlassen kann. Die Batteriezelle 10 umfasst nämlich eine Überprüfungseinheit 34, mittels welcher sich überprüfen lässt, ob das externe Steuergerät 30 eine Berechtigung zum Ausgeben des Befehls 32 hat. Nur wenn dies der Fall ist, führt der Mikrokontroller 26 tatsächlich den Befehl 32 aus und schließt beispielsweise das anfangs geöffnete Schaltelement 24. Bei geöffnetem Schaltelement 24 liegt an den elektrischen Anschlüssen 20, 22 der Batteriezelle 10 keine elektrische Spannung an. Erst nach dem Schließen des Schaltelements 24 ist die Batteriezelle 10 somit scharf geschaltet, sodass die Spannung des galvanischen Elements 14 an den elektrischen Anschlüssen 20, 22 anliegt.

Der Mikrokontroller 26 kann über eine Ansteuerleitung 36 das Schaltelement 24 mit einer Steuerspannung beaufschlagen und so insbesondere das Öffnen oder Schließen des Schaltelements 24 bewirken. Der Mikrokontroller 26 ist vorliegend nicht nur mit dem Schaltelement 24 wirkverbunden, sondern auch mit weiteren derartigen Funktionseinheiten der Batteriezelle 10.

Beispielsweise ist der Mikrokontroller 26 über eine weitere Ansteuerleitung 38 mit einem weiteren Schaltelement 40 wirkverbunden. Dieses weitere Schaltelement 40 ist in einer Leitung 42 angeordnet, welche die beiden Ableiter 16, 18 miteinander verbindet. In der Leitung 42 befindet sich auch ein Widerstandselement 44. Steuert der Mikrokontroller 26 das Schaltelement 40 an, so kann ein Entladen, insbesondere ein Tiefentladen, des galvanischen Elements 14 bewirkt werden. Durch das Tiefentladen kann die Batteriezelle 10 unbrauchbar gemacht werden. Dann kann sie gefahrlos transportiert und beispielsweise einer Entsorgung oder einer Recyclingmaßnahme zugeführt werden. Auch wenn das externe Steuergerät 30 den Befehl 32 an den Mikrokontroller 26 ausgibt, das weitere Schaltelement 40 zu schließen, wird vorliegend die Berechtigung des externen Steuergeräts 30 zum Ausgeben des Befehls 32 mittels der Überprüfungseinheit 34 überprüft. Hierfür kann beispielsweise der Befehl 32 verschlüsselt sein, und die Überprüfungseinheit 34 ist dazu ausgebildet, den Befehl 32 zu entschlüsseln.

Für die Kommunikation des Mikrokontrollers 26 mit dem externen Steuergerät 30 kann eine Kommunikationseinrichtung vorgesehen sein, welche vorliegend schematisch als Funkantenne 46 ausgebildet gezeigt ist und so zur drahtlosen Kommunikation mit dem Steuergerät 30 geeignet ist. Zusätzlich oder alternativ kann jedoch auch eine leitungsgebundene Kommunikation vorgesehen sein.

Zum Verschlüsseln der gesamten Kommunikation oder von Teilen der Kommunikation, sei es von dem Steuergerät 30 hin zum Mikrokontroller 26 und/oder vom Mikrokontroller 26 hin zum Steuergerät 30, können verschiedene Verschlüsselungsmethoden eingesetzt werden. So kann beispielsweise eine symmetrische Verschlüsselung gemäß AES-128 eingesetzt werden. Zusätzlich oder alternativ können asymmetrische Verschlüsselungsverfahren gemäß PGP (pretty good privacy) zum Einsatz kommen. Hierfür können in der Batteriezelle 10, beispielsweise in einem Speicher 48, private und öffentliche Schlüssel hinterlegt sein. Der Speicher 48 kann an den Mikrokontroller 26 angebunden sein. Zusätzlich oder alternativ kann ein Speicher 50 vorgesehen sein, welcher in den Mikrokontroller 26 oder eine derartige Recheneinheit integriert ist.

Vorliegend umfasst der Speicher 48 einen nicht flüchtigen Speicher 52 und einen einmal programmierbaren Speicher, also einen OTP-Speicher 54 (OTP = one time programmable) (vergleiche Fig. 2).

Wenn eine verschlüsselte Kommunikation mittels privater und öffentlicher Schlüssel vorgesehen ist, kann der jeweilige Schlüssel beispielsweise mindestens dreifach im jeweiligen Speicher 52, 54 abgelegt sein. Hierbei kann der Schlüssel insbesondere zusammen mit einem Error-Correction-Code (ECC, Fehlerkorrekturcode) gespeichert sein. Der Error-Correction-Code ist bevorzugt dazu ausgebildet, zwei Bitkipper oder Bitfehler zu identifizieren und einen Bitkipper oder Bitfehler zu korrigieren.

Die privaten Schlüssel befinden sich bevorzugt im OTP-Speicher 54 und der oder die öffentlichen Schlüssel sowohl im OTP-Speicher 54 als auch im nicht flüchtigen Speicher 52. Die öffentlichen Schlüssel können dann von dem externen Steuergerät 30 ausgelesen werden, wenn dieses zur Kommunikation mit dem Mikrokontroller 26 berechtigt ist.

Insbesondere die privaten Schlüssel ermöglichen eine verschlüsselte Kommunikation beim Ansteuern oder Auslesen der Funktionseinheiten der Batteriezelle 10, etwa beim Ansteuern der Schaltelemente 24, 40. Jedoch kann auch das Zugreifen auf den Speicher 48 mittels eines, insbesondere privaten, Schlüssels abgesichert sein. Es kann nämlich auch der Speicher 48 selber eine der Funktionseinheiten der Batteriezelle 10 sein, mit welcher der Mikrokontroller 26 wirkverbunden ist. Ein Zugriff von dem externen Steuergerät 30 auf den Speicher 48 erfolgt dann jedoch nicht direkt, sondern über den Mikrokontroller 26. So kann mittels der Überprüfungseinheit 34 zunächst festgestellt werden, ob ein solcher Zugriff überhaupt zugelassen werden soll.

In dem Speicher 48 kann als Kennung für die jeweilige Batteriezelle 10 beispielsweise eine digitale öffentliche Identifikationsnummer 56 abgelegt sein (vergleiche Fig. 2), mittels welcher sich die jeweilige Batteriezelle 10 eineindeutig identifizieren lässt. Eine solche öffentliche Identifikationsnummer 56 kann insbesondere dreifach im Speicher 48 abgelegt sein und dies bevorzugt zusammen mit einem Error-Correction-Code (ECC). Dieser Error-Correction-Code ist bevorzugt dazu ausgebildet, mindestens zwei Bitkipper zu identifizieren und einen Bitkipper zu korrigieren. Vorliegend ist die Identifikationsnummer 56 dreifach im OTP-Speicher 54 abgelegt und bevorzugt in Kopie auch im nicht flüchtigen oder nicht volatilen Speicher 52.

Das dreifache Vorsehen etwa der Identifikationsnummer 56 und/oder der Schlüssel sorgt für eine besonders große Sicherheit. Beispielsweise kann nämlich vorgesehen sein, dass alle drei Identifikationsnummern 56 ausgelesen werden müssen, damit bei Übereinstimmung der drei Identifikationsnummern 56 auf deren Richtigkeit geschlossen wird. Auch kann ein gestaffeltes Auslesen der drei Identifikationsnummern 56 vorgesehen sein, bei welchem auf die zweite Identifikationsnummer 56 erst dann zugegriffen wird, wenn eine Fehlererkennung beim Auslesen der ersten Identifikationsnummer 56 das Vorliegen eines Fehlers als wahrscheinlich festgestellt hat.

Wenn die Überprüfungseinheit 34 die Berechtigung des externen Steuergeräts 30 zum Ausgeben von Befehlen 32 festgestellt hat, so kann die Identifikationsnummer 56 ausgelesen werden. Zusammen mit der Identifikationsnummer 56 können dann beispielsweise der Zustand der Schaltelemente 24, 40, die Spannung der Batteriezelle 10 sowie Werte, welche einen Stromfluss in die Batteriezelle 10 oder aus der Batteriezelle 10 angeben, und dergleichen dem externen Steuergerät 30 kommuniziert werden.

Des Weiteren ist vorliegend der Mikrokontroller 26 mit Sensoreinrichtungen 58 wirkverbunden, welche in der Lage sind, weitere die Batteriezelle 10 betreffende Parameter zu erfassen. Beispielsweise können mittels der Sensoreinrichtungen 58 eine Temperatur und ein Druck im Inneren des Batteriezellengehäuses 12, eine Beschaffenheit des Elektrolyten des galvanischen Elements 14, Beschleunigungen und/oder mechanische Spannungen oder Kräfte erfasst werden, welchen die Batteriezelle 10 ausgesetzt ist. Mittels der Sensoreinrichtungen 58 erfassbare Parameter werden vorliegend in dem Speicher 48 abgelegt. Es kann vorgesehen sein, dass einige der entsprechenden Informationen von dem externen Steuergerät 30 ausgelesen werden können, sobald dieses die Identifikationsnummer 56 der Batteriezelle 10 kennt. Beispielsweise können derartige Parameter die Spannung, die Temperatur der Batteriezelle 10 und den Druck der Batteriezelle 10 umfassen. Es kann jedoch vorgesehen sein, dass bestimmte Daten, welche im Speicher 48 abgelegt sind, nicht ohne Weiteres öffentlich zugänglich gemacht werden. So kann vorgesehen sein, dass der Mikrokontroller 26 die mittels der Sensoreinrichtungen 58 erfassten Daten verschlüsselt in dem Speicher 48 ablegt und lediglich das Auslesen derjenigen Daten mittels des externen Steuergeräts 30 zulässt, welches dazu berechtigt ist.

Des Weiteren kann vorgesehen sein, dass beispielsweise im OTP-Speicher 54 des Mikrokontrollers 26 ein Schlüssel insbesondere dreifach und bevorzugt mit Error-Correction-Code abgelegt ist, welcher der Verschlüsselung der in den volatilen Speicher 52 zu schreibenden Daten dient und auch beim Auslesen dieser Daten verwendet wird. Dadurch ist sichergestellt, dass ein Zugriff auf den Speicher 48 lediglich über den lokalen Mikrokontroller 26 möglich ist. Selbst wenn also das Steuergerät 30 zur Kommunikation mit dem Mikrokontroller 26 berechtigt und quasi freigeschaltet ist, erfolgt der eigentliche Zugriff auf den Speicher 48 und damit auf die verschlüsselten und vom Mikrokontroller 26 zu entschlüsselnden Daten über diese lokale Recheneinheit.

Es können auch für die verschiedenen Funktionen unterschiedliche, insbesondere private Schlüssel vorgesehen sein. Auch kann eine gestaffelte Sicherheit vorgesehen sein, bei welcher ein Zugriff auf eine nächst höhere Ebene erst nach Freischalten der nächst tieferen Ebene möglich ist. Über solche mehrstufig abgesicherte Funktionen können verschiedene Geheimnisebenen bereitgestellt werden, etwa für das Speichern von Daten, für das Lesen von Daten oder für das Überschreiben von Daten in dem Speicher 48. Auch das Betreiben der Schaltelemente 24, 40 oder dergleichen Trennschalter kann vom vorherigen Freischalten einer hierarchisch übergeordneten Ebene abhängig gemacht werden.

Beim Prüfen der Berechtigung des externen Steuergeräts 30 zum Ausgeben von Befehlen 32 an den Mikrokontroller 26 kann vorgesehen sein, dass die Befehlsfolge eine Identifikationsnummer oder dergleichen Kennung des externen Steuergeräts 30 und die Identifikationsnummer 56 der anzusprechenden Batteriezelle 10 umfasst. Des Weiteren kann die Befehlsfolge den zum Betätigen des Schaltelements 24, 40 vorgesehenen Befehl umfassen. Des Weiteren kann vorgesehen sein, dass der Befehl 32 zum Betätigen der Schaltelemente 24, 40 einen Zeitstempel und/oder einen Energiewert der Batteriezelle 10 umfasst. Ein solcher Zeitstempel oder Energiewert kann zudem verschlüsselt sein. Darüber hinaus kann vorgesehen sein, dass die Befehlsfolge einen Error-Correction-Code enthält.

Wenn zum Betätigen des Schaltelements 24, 40 oder eines derartigen Trennschalters der Zeitstempel und/oder der Energiewert der Batteriezelle 10 in dem Befehl 32 enthalten ist, so kann sichergestellt werden, dass ein Abhören der entsprechenden Kommunikation und ein späteres unlauteres Nutzen des kopierten Befehls nicht funktionieren. Der Energiewert der Batteriezelle 10 kann die Energiemenge angeben, welche bislang in die Batteriezelle 10 eingebracht wurde und von der Batteriezelle 10 abgegeben wurde.

Insbesondere das Schließen des Schaltelements 24 ist ein sensibler Vorgang, da durch dieses die Batteriezelle 10 oder gar die gesamte Batterie 28 scharf geschaltet wird, sodass an den Anschlüssen 20, 22 der Batteriezelle 10 beziehungsweise an Hochvoltanschlüssen der Batterie 28 eine Spannung anliegt. Es kann daher vorgesehen sein, dass nach dem Ausgeben des Befehls 32, welcher den Mikrokontroller 26 veranlasst das Schaltelement 24 zu schließen, nach Ablauf einer vorbestimmten Zeitspanne und/oder nach einem bestimmten Energiefluss in die Batteriezelle 10 oder aus der Batteriezelle 10 ein erneuter Befehl 32 ausgegeben werden muss, damit das Schaltelement 24 auch geschlossen bleibt.

Hierfür kann die Überprüfungseinheit 34 einen Baustein 60 umfassen (vergleiche Fig. 2), welcher das Erneuern des Befehls 32 überprüft, also das Ausgeben eines sogenannten keep-alive-Befehls. Das Vorsehen des Bausteins 60 zum Überprüfen des keep-alive-Befehls sorgt dafür, dass die Batteriezellen 10 automatisch abgeschaltet werden, wenn über eine entsprechend lange Zeit hinweg keine Kommunikation des externen Steuergeräts 30 mit den Batteriezellen 10 erfolgt ist. Wenn also beispielsweise nach einer bestimmten Anzahl von Stunden und/oder Wattsekunden kein keep-alive-Befehl von dem Baustein 60 erfasst wird, so muss die Funktion des Ansprechens des Mikrokontrollers 26 zum Schließen des Schaltelements 24 erneut freigeschalten werden.

Der keep-alive-Befehl kann beispielsweise die Identifikationsnummern 56 aller Batteriezellen 10 der Batterie 28 (vergleiche Fig. 4) umfassen. So kann sichergestellt werden, dass bei Austausch einer der Batteriezellen 10 oder einer derartigen Manipulation nach Ablauf der vorgesehenen Zeitspanne oder nach Erreichen des vorbestimmten Werts des Energieflusses kein weiterer Betrieb der Batterie 28 möglich ist. So können Manipulationen an der Batterie 28 besonders weitgehend vermieden werden.

In Fig. 2 ist veranschaulicht, dass erst nach einer Freigabe 62 beispielsweise auf die im Speicher 48 abgelegten Daten zugegriffen oder die Schaltelemente 24, 40 betrieben werden dürfen.

Anhand von Fig. 3 soll eine Möglichkeit des Freischaltens des externen Steuergeräts 30 veranschaulicht werden. Es kann nämlich vorgesehen sein, dass das externe Steuergerät 30 vorab mit weiteren Steuergeräten des Kraftfahrzeugs kommunizieren muss, um zum Ausgeben des Befehls 32 berechtigt zu sein. So kann eine Kommunikation des externen Steuergeräts 30 mit einem Batteriemanagementsystem 64 und zusätzlich oder alternativ mit einem Batteriesicherungskasten 66, einer Leistungselektronik 68 und/oder einem Ladegerät 70 vorgesehen sein, um das externe Steuergerät 30 freizuschalten. In dem Batteriesicherungskasten 66, welcher auch als Battery-Junction-Box (BJB) bezeichnet wird, befinden sich die Hochvoltschütze der Batterie 28. Es kann vorgesehen sein, dass erst nach einem Austausch entsprechender Kennungen dieser Steuergeräte oder Komponenten das externe Steuergerät 30 zur Kommunikation mit der Batteriezelle 10 freigeschaltet ist.

Hierfür kann beispielsweise im nicht flüchtigen Speicher 52 der Batteriezelle 10 eine Identifikationsnummer des externen Steuergeräts 30 abgelegt sein, welche eine Nummer des Batteriesicherungskastens 66 und/oder des Ladegeräts 70 umfasst. Meldet sich dann das Steuergerät 30 mit dieser Identifikationsnummer, so kann die Überprüfungseinheit 34 der Batteriezelle 10 feststellen, dass dasjenige externe Steuergerät 30 mit der Batteriezelle 10 kommuniziert, welches zu dem gleichen Kraftfahrzeug gehört wie zumindest eine weitere der in Fig. 3 gezeigten Komponenten. Nach diesem Freischalten des externen Steuergeräts 30 können dann insbesondere die Befehle 32 für das Betreiben der Schaltelemente 24, 40 und für das Zugreifen auf den Speicher 48 von dem externen Steuergerät 30 an die Batteriezelle 10 ausgegeben werden.

Nachdem so generell die Funktion des Betreibens der Trennschalter oder Schaltelemente 24, 40 freigeschaltet ist, können die jeweiligen Befehle 32 für den Betrieb der Schaltelemente 24, 40 eingesetzt werden. Schlüssel dieser Befehle 32 können im OTP-Speicher 54 beispielsweise dreimal mit einem jeweiligen Error-Correction-Code abgelegt sein und nach dem Freischalten des externen Steuergeräts 30 von dem externen Steuergerät 30 ausgelesen werden. Diese Befehle 32 können das Schließen und Öffnen des Schaltelements 24 und den keep-alive-Befehl zum Geschlossenhalten des Schaltelements 24 umfassen. Des Weiteren kann das Entladen und insbesondere Tiefentladen der Batteriezelle 10 durch Schließen des Schaltelements 40 mittels des von dem freigeschalteten Steuergerät 30 ausgegebenen Befehls 32 bewirkt werden.

Wenn der Mikrokontroller 26 die Daten verschlüsselt in dem Speicher 48 ablegt, so erfolgt selbst nach dem Freischalten des externen Steuergeräts 30 der eigentliche Speicherzugriff lediglich über den Mikrokontroller 26. Bei einer Zerstörung oder Beschädigung des Mikrokontrollers 26 ist dann auch kein Zugriff mehr auf den Speicher 48 möglich. Insbesondere ist es nicht mehr möglich, die im nicht flüchtigen Speicher 52 abgelegten Daten auszulesen.

Des Weiteren kann vorgesehen sein, dass unabhängig von der Identifikationsnummer 56 der Batteriezelle 10 eine Notfallnachricht oder ein derartiger Sonderbefehl 72 das Öffnen des Schaltelements 24 bewirken kann (vergleiche Fig. 2). Ein solcher Sonderbefehl 72 kann zum Beispiel dann eingesetzt werden, wenn nach einem Unfall des die Batterie 28 aufweisenden Kraftfahrzeugs die Batterie 28 spannungsfrei geschaltet werden soll. Eine entsprechende Notfallnachricht kann beispielsweise mindestens 1.024 Bit lang sein. Zusätzlich oder alternativ kann ein Sonderbefehl 72 das Tiefentladen der Batteriezelle 10 durch Schließen des Schaltelements 40 bewirken.

Wie aus Fig. 1 ersichtlich ist, kann der Mikrokontroller 26 oder ein den Mikrokontroller 26 umfassender Chip ein Sicherungselement 74 etwa in Form von sogenannten Fusedrähten oder dergleichen aufweisen. Solche Fusedrähte, welche auch als Tripwires bezeichnet werden, werden vorliegend durchtrennt, wenn jemand versucht, den Mikrokontroller 26 zu öffnen, um an sein Geheimnis zu gelangen. Der Mikrokontroller 26 erkennt dies im Betrieb entweder unverzüglich oder nach dem nächsten Starten. Daraufhin kann der Mikrokontroller 26 eine Intrusionssequenz im nicht flüchtigen Speicher 52 und/oder im OTP-Speicher 54 programmieren. Findet der Mikrokontroller 26 eine solche Intrusionssequenz dann vor dem Ausführen eines Zugriffs auf den Speicher 48 vor, so wird jeder weitere Speicherzugriff also insbesondere ein Lesen und/oder Schreiben unterbunden. Es kann auch dafür gesorgt werden, das alle Daten gelöscht werden, welche in dem Speicher 48 der Batteriezelle 10 abgelegt sind.

Durch das vorstehend beschriebene, insbesondere mehrstufige digitale Sicherheitskonzept wird eine Reihe von vorteilhaften Funktionen realisiert. Insbesondere kann die Historie der Batteriezelle 10 sicher verschlüsselt im Speicher 48 abgelegt werden, und dennoch wird das Leben der Batteriezelle 10, etwa in Bezug auf Werte des Stroms, der Spannung, der Temperatur und dergleichen bevorzugt lückenlos dokumentiert. Des Weiteren ist ein gesicherter Zugang zu den verschiedenen Ebenen gewährleistet. Beispielsweise bekommt eine Funktionsinstanz oder auch eine Prüfinstanz, welche die Batterie 28 oder die einzelnen Batteriezellen 10 wartet, jeweils nur den benötigten Zugang. Insbesondere kann nur eine berechtigte externe Recheneinheit etwa in Form des externen Steuergeräts 30 die Schaltelemente 24, 40 betätigen.

In Bezug auf ein Aufzeichnen oder Ablegen der Daten im Speicher 48 kann vorgesehen sein, dass dies auf den Befehl 32 hin erfolgt. Es kann jedoch auch vorgesehen sein, dass ein solches Speichern der Daten grundsätzlich ständig erfolgt, wobei jedoch mittels des Befehls 32 festgelegt werden kann, dass über eine bestimmte Zeitspanne hinweg keine Daten im Speicher 48 abgelegt werden oder welche Art von Daten dort abgelegt werden soll. Das Einschalten eines ständigen Loggens oder Aufzeichnens der Daten kann beispielsweise über entsprechende Speicherstellen im OTP-Speicher 54 erreicht werden.

Des Weiteren kann vorgesehen sein, dass bestimmte Funktionen einmalig aktiviert oder deaktiviert werden. Auch hierfür können insbesondere im OTP-Speicher 54 entsprechende Speicherstellen vorgesehen sein. Dies ermöglicht beispielsweise die Anpassung des Betriebs des Mikrokontrollers 26 an einen jeweiligen Typ von Batteriezellen 10. Beispielsweise können bestimmte Analysen oder Routinen, welche bei einem bestimmten Typ der Batteriezelle 10 nicht benötigt werden, abgeschaltet werden, etwa um Energie zu sparen.

Darüber hinaus erfolgt vorliegend ein Deaktivieren der Batteriezelle 10, wenn die Batteriezelle 10 für einen Zugang zum Mikrokontroller 26 geöffnet oder zerstört wird. Dadurch, dass bevorzugt zunächst das externe Steuergerät 30 freizuschalten ist, ist ein sogenanntes verteiltes Geheimnis realisiert, welches Sicherheit gegenüber einem unerwünschten Tuning und einen Diebstahlschutz bietet. Auch das Betätigen der Schaltelemente 24, 40, welche insbesondere als Leistungstransistoren ausgebildet sein können, wird vorliegend erst nach der Geheimnisübertragung aktiviert, und zwar bevorzugt für einen bestimmten Zeitraum. Das wiederholte Übermitteln von keep-alive-Befehlen an den Mikrokontroller 26 sichert dann die kontinuierlich kontrollierte Funktion beziehungsweise das am-Netz-Bleiben der Batteriezelle 10.

Dadurch, dass das externe Steuergerät 30 des Kraftfahrzeugs nur bekannte beziehungsweise vorher angelernte Batteriezellen 10 ansprechen kann oder darf, ist des Weiteren ein Schutz von Originalteilen sichergestellt. Hierdurch wird die Verwendung von falschen und/oder ungeeigneten und/oder gestohlenen Batteriezellen 10 unterbunden. Auch ist ein Schutz vor Vandalismus gewährleistet, etwa indem ein externes Öffnen der Batteriezelle 10 anhand einer Beschädigung des Sicherungselements 74 festgestellt werden kann.

Des Weiteren wird ein Versuch eines Speicherzugriffs durch einen nicht dem Original entsprechenden Mikrokontroller 26 erkannt, da der Mikrokontroller 26 in der Lage ist, eine Intrusionssequenz im Speicher 48 abzulegen. Bei erkanntem Vandalismus kann beispielsweise mittels einer solchen Intrusionssequenz dafür gesorgt werden, dass die im Speicher 48 abgelegten Daten unbrauchbar gemacht oder der Zugriff verhindert wird.

Der Mikrokontroller 26 kann im Speicher 48 auch die Identifikationsnummer des externen Steuergeräts 30 speichern. Dann ist auch eineindeutig nachvollziehbar, in welchem Fahrzeug die Batteriezelle 10 eingesetzt wurde und wie sich die jeweilige Historie der Batteriezellen 10 in diesem Fahrzeug darstellt.

Es kann auch das externe Steuergerät 30 die Identifikationsnummern 56 aller Batteriezellen 10 speichern, sodass im Kreuzvergleich die Lebenshistorie aller Batteriezellen 10 eineindeutig nachverfolgt werden kann. Dies sichert den Wert der Batteriezellen 10, insbesondere für eine spätere Verwendung im Rahmen von alternativen Anwendungen, also sogenannter second-life-Anwendungen.

Es kann auch vorgesehen sein, dass durch ein gewolltes aktives Zerstören des Sicherungselements 74 (etwa durch Beaufschlagen der Fusedrähte mit einem entsprechenden Strom) oder durch eine Befehlsfolge eine aktive Entladung der Batteriezelle 10 eingeleitet wird. Das aktive Entladen kann durch Schließen des Schaltelements 40 bewerkstelligt werden. Zugleich kann hierbei ein späteres Schließen des Schaltelements 24 unmöglich gemacht werden.

## Patentansprüche

1. Batteriezelle für eine Batterie (28) eines Kraftfahrzeugs mit einem Batteriezellengehäuse (12), in welchem ein galvanisches Element (14) aufgenommen ist, mit zwei elektrischen Anschlüssen (20, 22), über welche die Batteriezelle (10) mit wenigstens einer weiteren Batteriezelle (10) der Batterie (28) elektrisch verbindbar ist, und mit einer Steuerungseinrichtung (26), welche mit wenigstens einer Funktionseinheit der Batteriezelle (10) wirkverbunden ist,
wobei die Steuerungseinrichtung (26) der Batteriezelle (10) dazu ausgebildet ist, einen von einer externen Steuerungseinrichtung (30) ausgegebenen Befehl (32) zu empfangen, wobei die Batteriezelle (10) eine von der externen Steuerungseinrichtung (30) auslesbare Kennung (56) aufweist,
**dadurch gekennzeichnet, dass**
die Steuerungseinrichtung (26) eine Überprüfungseinheit (34) umfasst, welche dazu ausgebildet ist, eine Berechtigung der externen Steuerungseinrichtung (30) zum Ausgeben des Befehls (32) zu überprüfen, wobei die Kennung (56) von jeder externen Steuerungseinrichtung (30) ausgelesen werden kann, welche berechtigt ist, mit der Steuerungseinrichtung (26) der Batteriezelle (10) zu kommunizieren, wobei
- die wenigstens eine Funktionseinheit der Batteriezelle (10) ein Schaltelement (24) umfasst, welches zum Unterbrechen und zum Herstellen einer elektrisch leitenden Verbindung zwischen einem Ableiter (16, 18) des galvanischen Elements (14) und zumindest einem der elektrischen Anschlüsse (20, 22) ausgebildet ist, wobei die Steuerungseinrichtung (26) der Batteriezelle (10) dazu ausgebildet ist, auf den Befehl (32) hin einen Schaltzustand des Schaltelements (24) zu verändern, und/oder
- die wenigstens eine Funktionseinheit der Batteriezelle (10) ein Schaltelement (40) umfasst, welches in einer Leitung (42) angeordnet ist, welche Ableiter (16, 18) des galvanischen Elements (14) miteinander verbindet, wobei in der Leitung (42) ein Widerstandselement (44) angeordnet ist, wobei die Steuerungseinrichtung (26) der Batteriezelle (10) dazu ausgebildet ist, auf den Befehl (32) hin das Schaltelement (40) zu schließen,
und wobei die Steuerungseinrichtung (26) der Batteriezelle (10) dazu ausgebildet ist, beim Empfangen wenigstens eines vorbestimmten Sonderbefehls (72) unabhängig von der Kennung (56) der Batteriezelle (10) das zwischen dem Ableiter (16, 18) und dem zumindest einen elektrischen Anschluss (20, 22) angeordnete Schaltelement (24) zu öffnen und/oder das in der Leitung (42) angeordnete Schaltelement (40) zu schließen.

2. Batteriezelle nach Anspruch 1,
**dadurch gekennzeichnet, dass**
die wenigstens eine Funktionseinheit der Batteriezelle einen Speicher (48) zum Speichern von Datenwerten umfasst, welche mittels wenigstens einer Sensoreinrichtung (58) der Batteriezelle (10) erfassbare Parameter angeben, wobei die Steuerungseinrichtung (26) der Batteriezelle (10) dazu ausgebildet ist, auf den Befehl (32) hin auf den Speicher (48) zuzugreifen.

3. Batteriezelle nach Anspruch 1 oder 2,
**gekennzeichnet durch**
- wenigstens einen Schlüssel zum Verschlüsseln von an die externe Steuerungseinrichtung (30) zu übermittelnden Informationen und/oder in einem Speicher (48) der Batteriezelle (10) abzulegenden Daten und/oder zum Entschlüsseln des von der externen Steuerungseinrichtung (30) ausgegebenen Befehls (32) und/oder
- eine mittels der Überprüfungseinheit (34) durchführbare Zugriffskontrolle, bei welcher das vorherige Ausführen eines ersten, hierarchisch übergeordneten Befehls (32) die Voraussetzung für das Ausführen eines zweiten, hierarchisch untergeordneten Befehls (32) ist.

4. Batteriezelle nach einem der Ansprüche 1 bis 3,
**dadurch gekennzeichnet, dass**
die Steuerungseinrichtung (26) der Batteriezelle (10) wenigstens ein Sicherungselement (74) aufweist, welches derart angeordnet ist, dass es infolge eines mechanischen Manipulierens der Steuerungseinrichtung (26) beschädigt wird.

5. Batterie mit einer Mehrzahl von in Reihe und/oder parallel geschalteten Batteriezellen (10) nach einem der Ansprüche 1 bis 4.

6. Kraftfahrzeug mit zumindest einer Batterie nach Anspruch 5.

7. Verfahren zum Betreiben einer Batteriezelle (10) für eine Batterie (28) eines Kraftfahrzeugs mit einem Batteriezellengehäuse (12), in welchem ein galvanisches Element (14) aufgenommen ist, mit zwei elektrischen Anschlüssen (20, 22), über welche die Batteriezelle (10) mit wenigstens einer weiteren Batteriezelle (10) der Batterie (28) elektrisch verbindbar ist, und mit einer Steuerungseinrichtung (26), welche mit wenigstens einer Funktionseinheit der Batteriezelle (10) wirkverbunden ist,
wobei eine Steuerungseinrichtung (26) der Batteriezelle (10) einen von einer externen Steuerungseinrichtung (30) ausgegebenen Befehl (32) empfängt, wobei die Batteriezelle (10) eine von der externen Steuerungseinrichtung (30) auslesbare Kennung (56) aufweist,
**dadurch gekennzeichnet, dass**
die Steuerungseinrichtung (26) eine Überprüfungseinheit (34) umfasst, welche eine Berechtigung der externen Steuerungseinrichtung (30) zum Ausgeben des Befehls (32) überprüft, wobei die Kennung (56) von jeder externen Steuerungseinrichtung (30) ausgelesen werden kann, welche berechtigt ist, mit der Steuerungseinrichtung (26) der Batteriezelle (10) zu kommunizieren, wobei
- die wenigstens eine Funktionseinheit der Batteriezelle (10) ein Schaltelement (24) umfasst, welches zum Unterbrechen und zum Herstellen einer elektrisch leitenden Verbindung zwischen einem Ableiter (16, 18) des galvanischen Elements (14) und zumindest einem der elektrischen Anschlüsse (20, 22) ausgebildet ist, wobei die Steuerungseinrichtung (26) der Batteriezelle (10) dazu ausgebildet ist, auf den Befehl (32) hin einen Schaltzustand des Schaltelements (24) zu verändern, und/oder
- die wenigstens eine Funktionseinheit der Batteriezelle (10) ein Schaltelement (40) umfasst, welches in einer Leitung (42) angeordnet ist, welche Ableiter (16, 18) des galvanischen Elements (14) miteinander verbindet, wobei in der Leitung (42) ein Widerstandselement (44) angeordnet ist, wobei die Steuerungseinrichtung (26) der Batteriezelle (10) dazu ausgebildet ist, auf den Befehl (32) hin das Schaltelement (40) zu schließen,
und wobei die Steuerungseinrichtung (26) der Batteriezelle (10) beim Empfangen wenigstens eines vorbestimmten Sonderbefehls (72) unabhängig von der Kennung (56) der Batteriezelle (10) das zwischen dem Ableiter (16, 18) und dem zumindest einen elektrischen Anschluss (20, 22) angeordnete Schaltelement (24) öffnet und/oder das in der Leitung (42) angeordnete Schaltelement (40) schließt.

## Claims

1. Battery cell for a battery (28) of a motor vehicle with a battery cell housing (12), in which a galvanic element (14) is accommodated, with two electrical connections (20, 22), via which the battery cell (10) can be electrically connected with at least one further battery cell (10) of the battery (28), and with a control device (26) which is operatively connected with at least one functional unit of the battery cell (10),
wherein the control device (26) of the battery cell (10) is configured to receive a command (32) outputted from an external control device (30), wherein the battery cell (10) has an identifier (56) which can be read out by the external control device (30),
**characterised in that**
the control device (26) comprises a verification unit (34) which is configured to verify an authorisation of the external control device (30) to output the command (32), wherein the identifier (56) can be read out from every external control device (30) which is authorised to communicate with the control device (26) of the battery cell (10), wherein
- the at least one functional unit of the battery cell (10) comprises a switching element (24) which is configured to interrupt and to establish an electrically conducting connection between a charge eliminator (16, 18) of the galvanic element (14) and at least one of the electrical connections (20, 22), wherein the control device (26) of the battery cell (10) is configured, upon the command (32), to alter a switching state of the switching element (24), and/or
- the at least one functional unit of the battery cell (10) comprises a switching element (40) which is disposed in a line (42) which connects charge eliminators (16, 18) of the galvanic element (14) with one another, wherein in the line (42) is disposed a resistance element (44), wherein the control device (26) of the battery cell (10) is configured, upon the command (32), to close the switching element (40),
and wherein the control device (26) of the battery cell (10) is configured, at the reception of at least one predetermined special command (72), independently of the identifier (56) of the battery cell (10) to open the switching element (24) disposed between the charge eliminator (16, 18) and the at least one electrical connection (20, 22) and/or to close the switching element (40) disposed in the line (42).

2. Battery cell according to claim 1,
**characterised in that**
the at least one functional unit of the battery cell comprises a store (48) for storing data values, which by means of at least one sensor device (58) of the battery cell (10) specify recordable parameters, wherein the control device (26) of the battery cell (10) is configured, upon the command (32) to access the store (48).

3. Battery cell according to claim 1 or 2,
**characterised by**
- at least one key for encrypting information to be transmitted to the external control device (30) and/or data to be deposited in a store (48) of the battery cell (10) and/or for the decrypting the command (32) outputted from the external control device (30) and/or
- an access control which can be carried out by means of the verification unit (34), in the case of which the previous execution of a first, hierarchically superordinate command (32) is the prerequisite for the execution of a second, hierarchically subordinate command (32).

4. Battery cell according to any of claims 1 to 3,
**characterised in that**
the control device (26) of the battery cell (10) has at least one safety element (74) which is configured such that it is damaged as a result of a mechanical manipulation of the control device (26).

5. Battery having a plurality of battery cells (10) according to any of claims 1 to 4 connected in series and/or parallel.

6. Motor vehicle having at least one battery according to claim 5.

7. Method for operating a battery cell (10) for a battery (28) of a motor vehicle with a battery cell housing (12), in which a galvanic element (14) is accommodated, with two electrical connections (20, 22), via which the battery cell (10) can be electrically connected with at least one further battery cell (10) of the battery (28), and with a control device (26) which is operatively connected with at least one functional unit of the battery cell (10),
wherein a control device (26) of the battery cell (10) receives a command (32) outputted from an external control device (30), wherein the battery cell (10) has an identifier (56) which can be read out by the external control device (30),
**characterised in that**
the control device (26) comprises a verification unit (34) which verifies an authorisation of the external control device (30) to output the command (32), wherein the identifier (56) can be read out from every external control device (30) which is authorised to communicate with the control device (26) of the battery cell (10), wherein
- the at least one functional unit of the battery cell (10) comprises a switching element (24) which is configured to interrupt and to establish an electrically conducting connection between a charge eliminator (16, 18) of the galvanic element (14) and at least one of the electrical connections (20, 22), wherein the control device (26) of the battery cell (10) is configured, upon the command (32), to alter a switching state of the switching element (24), and/or
- the at least one functional unit of the battery cell (10) comprises a switching element (40) which is disposed in a line (42) which connects charge eliminators (16, 18) of the galvanic element (14) with one another, wherein in the line (42) is disposed a resistance element (44), wherein the control device (26) of the battery cell (10) is configured, upon the command (32), to close the switching element (40),
and wherein the control device (26) of the battery cell (10), at the reception of at least one predetermined special command (72), independently of the identifier (56) of the battery cell (10), opens the switching element (24) disposed between the charge eliminator (16, 18) and the at least one electrical connection (20, 22) and/or closes the switching element (40) disposed in the line (42).

## Revendications

1. Élément de batterie pour une batterie (28) de véhicule automobile avec un logement d'élément de batterie (12) au sein duquel est accueilli un élément galvanique (14), avec deux raccordements électriques (20, 22) par l'intermédiaire desquels l'élément de batterie (10) peut être raccordé électriquement à au moins un autre élément de batterie (10) de la batterie (28), et avec un dispositif de commande (26) qui est raccordé de manière effective à au moins une unité fonctionnelle de l'élément de batterie (10),
dans lequel le dispositif de commande (26) de l'élément de batterie (10) est conçu pour recevoir une instruction (32) émise par un dispositif de commande externe (30), dans lequel l'élément de batterie (10) présente un identifiant (56) pouvant être lu par le dispositif de commande externe (30),
**caractérisé en ce que**
le dispositif de commande (26) comprend une unité de vérification (34) conçue pour vérifier une autorisation du dispositif de commande externe (30) en vue d'émettre l'instruction (32), dans lequel l'identifiant (56) peut être lu par tout dispositif de commande externe (30) qui est autorisé à communiquer avec le dispositif de commande (26) de l'élément de batterie (10), dans lequel
- la au moins une unité fonctionnelle de l'élément de batterie (10) comprend un élément de commutation (24) conçu pour interrompre et pour établir une liaison électriquement conductrice entre un parasurtenseur (16, 18) de l'élément galvanique (14) et au moins un des raccordements électriques (20, 22), dans lequel le dispositif de commande (26) de l'élément de batterie (10) est conçu pour modifier un état de commutation de l'élément de commutation (24) sur la base de l'instruction (32), et/ou
- la au moins une unité fonctionnelle de l'élément de batterie (10) comprend un élément de commutation (40) agencé au sein d'une ligne (42) qui relie ensemble des parasurtenseurs (16, 18) de l'élément galvanique (14), dans lequel un élément de résistance (44) est agencé au sein de la ligne (42), dans lequel le dispositif de commande (26) de l'élément de batterie (10) est conçu pour fermer l'élément de commutation (40) sur la base de l'instruction (32),
et dans lequel le dispositif de commande (26) de l'élément de batterie (10) est conçu pour, en cas de réception d'au moins une instruction spéciale (72) prédéterminée et indépendamment de l'identifiant (56) de l'élément de batterie (10), ouvrir l'élément de commutation (24) agencé entre le parasurtenseur (16, 18) et le au moins un raccordement électrique (20, 22) et/ou fermer l'élément de commutation (40) agencé au sein de la ligne (42).

2. Élément de batterie selon la revendication 1,
**caractérisé en ce que**
la au moins une unité fonctionnelle de l'élément de batterie comprend une mémoire (48) destinée à stocker des valeurs de données représentant des paramètres pouvant être acquis au moyen d'au moins un dispositif de détection (58) de l'élément de batterie (10), dans lequel le dispositif de commande (26) de l'élément de batterie (10) est conçu pour accéder à la mémoire (48) sur la base de l'instruction (32).

3. Élément de batterie selon la revendication 1 ou 2,
**caractérisé par**
- au moins une clé destinée à crypter des informations à transmettre au dispositif de commande externe (30) et/ou des données à placer dans une mémoire (48) de l'élément de batterie (10) et/ou à décrypter l'instruction (32) émise par le dispositif de commande externe (30) et/ou
- un contrôle d'accès pouvant être mis en œuvre au moyen de l'unité de vérification (34), et pour lequel l'exécution précédente d'une première instruction (32) hiérarchiquement supérieure est la condition préalable à l'exécution d'une seconde instruction (32) hiérarchiquement inférieure.

4. Élément de batterie selon l'une quelconque des revendications 1 à 3,
**caractérisé en ce que**
le dispositif de commande (26) de l'élément de batterie (10) présente au moins un élément de sécurité (74) agencé de manière à être endommagé suite à une manipulation mécanique du dispositif de commande (26).

5. Batterie avec une pluralité d'éléments de batterie (10) commutés en série et/ou en parallèle selon l'une quelconque des revendications 1 à 4.

6. Véhicule automobile avec au moins une batterie selon la revendication 5.

7. Procédé d'exploitation d'un élément de batterie (10) pour une batterie (28) de véhicule automobile avec un logement d'élément de batterie (12) au sein duquel est accueilli un élément galvanique (14), avec deux raccordements électriques (20, 22) par l'intermédiaire desquels l'élément de batterie (10) peut être raccordé électriquement à au moins un autre élément de batterie (10) de la batterie (28), et avec un dispositif de commande (26) qui est raccordé de manière effective à au moins une unité fonctionnelle de l'élément de batterie (10),
dans lequel un dispositif de commande (26) de l'élément de batterie (10) reçoit une instruction (32) émise par un dispositif de commande externe (30), dans lequel l'élément de batterie (10) présente un identifiant (56) pouvant être lu par le dispositif de commande externe (30),
**caractérisé en ce que**
le dispositif de commande (26) comprend une unité de vérification (34) qui vérifie une autorisation du dispositif de commande externe (30) en vue d'émettre l'instruction (32), dans lequel l'identifiant (56) peut être lu par tout dispositif de commande externe (30) qui est autorisé à communiquer avec le dispositif de commande (26) de l'élément de batterie (10), dans lequel
- la au moins une unité fonctionnelle de l'élément de batterie (10) comprend un élément de commutation (24) conçu pour interrompre et pour établir une liaison électriquement conductrice entre un parasurtenseur (16, 18) de l'élément galvanique (14) et au moins un des raccordements électriques (20, 22), dans lequel le dispositif de commande (26) de l'élément de batterie (10) est conçu pour modifier un état de commutation de l'élément de commutation (24) sur la base de l'instruction (32), et/ou
- la au moins une unité fonctionnelle de l'élément de batterie (10) comprend un élément de commutation (40) agencé au sein d'une ligne (42) qui relie ensemble des parasurtenseurs (16, 18) de l'élément galvanique (14), dans lequel un élément de résistance (44) est agencé au sein de la ligne (42), dans lequel le dispositif de commande (26) de l'élément de batterie (10) est conçu pour fermer l'élément de commutation (40) sur la base de l'instruction (32),
et dans lequel le dispositif de commande (26) de l'élément de batterie (10), en cas de réception d'au moins une instruction spéciale (72) prédéterminée et indépendamment de l'identifiant (56) de l'élément de batterie (10), ouvre l'élément de commutation (24) agencé entre le parasurtenseur (16, 18) et le au moins un raccordement électrique (20, 22) et/ou ferme l'élément de commutation (40) agencé au sein de la ligne (42).
